# FASCICULE DE BREVET EUROPEEN

(11) **EP 0 468 442 B1**
(45) Date de publication et mention de la délivrance du brevet: **08.11.1995**
(21) Numéro de dépôt: 91112322.2
(22) Date de dépôt: 23.07.1991
(51) Int. Cl.: H04Q 3/00, H04L 12/00

(54) **Réseau d'interconnexion pour coeur d'installation de communication et installation dotée d'un tel réseau**
Verbindungsnetzwerk für das Zentrum einer Übertragungseinrichtung und Einrichtung ausgestattet mit einem solchen Netzwerk
Interconnection network for the centre of a communication installation and installation provided with such a network

(30) Priorité: 24.07.1990 FR 9009442
(43) Date de publication de la demande: 29.01.1992
(73) Titulaire: ALCATEL BUSINESS SYSTEMS, F-75008 Paris (FR)
(72) Inventeur: Gass, Raymond, F-67150 Bolsenheim (FR)
(74) Mandataire: Weinmiller, Jürgen

(56) Documents cités:
- GB-A- 2 098 027
- THE CONFERENCE ON COMPUTER COMMUNICATIONS '89 vol. 1, 23 Avril 1989, OTTAWA ,CA pages 127 - 135; IEEE NEW YORK, US ; M.J.LEE ET AL.: 'An Efficient Near-Optimal Algorithm for the Joint Traffic and Trunk Routing Problem in Self-Planning Networks'
- IEEE REGION 10 CONFERENCE vol. 2, 25 Août 1987, SEOUL, KO pages 313 - 316; IEEE, NEW YORK, US; J. VAN GASTEL ET AL.: 'Packet Switching: Proven Technology For Future Data Communication'
- TRANSACTIONS OF THE INSTITUTE OF ELECTRONICS AND COMMUNICATION vol. E-68, no. 2, Février 1985, TOKYO, JP pages 59 - 64; M. AKIYAMA ET AL.: 'Mesh Type Distributed Packet Switching Systems'

## Description

L'invention concerne un réseau d'interconnexion pour coeur d'installation de communication, notamment de type numérique à intégration de services et les installations dont le coeur est doté d'un tel réseau.

Les installations de communication de petite et moyenne capacités sont classiquement organisées autour d'un coeur d'installation qui est constitué par exemple par un commutateur numérique ou un système numérique d'intercommunication et qui est composé d'une pluralité d'unités constitutives modulaires et spécialisées qui sont interconnectées en fonction de leurs besoins en matière de communication.

Ces unités comprennent par exemple des unités d'entrée-sortie, notamment pour lignes analogiques ou numériques de rattachement de postes et/ou terminaux, ou pour jonctions permettant la mise en communication de l'installation avec des installations analogues extérieures. Elles comprennent aussi au moins une unité de commande, qui est le plus souvent organisée autour d'au moins un processeur et de mémoires associées, et des unités auxiliaires diverses, notamment d'application, dédiées par exemple à des fonctions de messagerie, de commutation de paquets ou de traitement de taxes.

Ces différentes unités sont usuellement portées par des cartes de circuit imprimé, par exemple individuelles par unités ou pour quelques unités identiques ou complémentaires, qui sont réparties dans des structures, notamment de type armoire ou coffret, chargées de les recevoir.

Le fonctionnement de l'installation dans l'environnement où elle est située, implique de nombreux échanges d'information, en particulier en interne entre les différentes unités d'équipement. Celles-ci sont donc reliées entre elles par un réseau d'interconnexion.

Dans une forme de réalisation connue, ce réseau s'organisait autour d'un commutateur temporel auquel les unités venaient se relier par l'intermédiaire de liaisons multiplexes temporelles partagées ou non sur lesquelles les informations transitaient dans le cadre de canaux isochrones. Une telle solution se prête mal aux transmissions d'information par paquets ce qui a conduit à l'apparition de réseaux d'interconnexion où toutes les unités sont reliées entre elles par des bus communément partagés.

Chaque unité a la possibilité de se réserver temporairement l'usage d'un bus, auquel elle est reliée, pour envoyer une information vers au moins une autre unité, elle-même reliée à ce bus. Celui-ci, voit par exemple, se succéder des informations transmises par paquets de longueur variable, ou fixe, transmis en mode asynchrone, avec des informations impliquant l'usage de canaux isochrones, tels que des signaux de parole numérisés MIC.

Toutefois le partage d'un même bus par des unités, parfois foncièrement différentes, ayant des besoins distincts et générant des trafics hétérogènes, conduit à retenir un format de transmission qui est obtenu par compromis en tenant compte tant des contraintes actuellement imposées que de celles, futures, qui sont déjà prévisibles et qui conduit à choisir un débit maximal admissible le plus élevé possible.

De ce fait de tels réseaux internes d'interconnexions sont relativement chers dans la mesure où ils doivent pouvoir satisfaire aux divers besoins et contraintes pris en compte.

De plus il arrive toujours un moment où le réseau n'est plus apte en raison de sa structure à satisfaire un besoin nouvellement apparu.

Il est par ailleurs connu un système de commutation de paquets à réseau maillé, par un article en Anglais intitulé "Mesh Type Distributed Packet Switching Systems" publié par M. AKIYAMA & al en Février 1985 dans le numéro 2 du volume E68 de "TRANSACTION of the IECE of JAPAN <p.59 à 64>. Ce réseau prévoit que toutes les unités de commutation de paquet soient interconnectées deux par deux par des liaisons point-à-point.

La présente invention propose donc un réseau d'interconnexion pour installation de communication, notamment de type numérique à intégration de services comportant une pluralité d'unités constitutives, spécialisées et modulaires, communiquant entre elles suivant leurs spécialisations respectives et en fonction des services de communication mis en oeuvre, par l'intermédiaire de liaisons physiques, de type point-à-point, reliant chacune deux des unités de l'installation ayant à communiquer entre elles.

Selon une caractéristique de l'invention, le réseau comporte des liaisons physiques, point-à-point de type électrique, qui sont regroupées sur une carte, dite de fond de panier, réalisée sous la forme d'un circuit multicouche comportant des positions de carte d'unité matérialisées par des moyens de connexion pour carte d'unité, chaque position de carte, équipée ou non, y étant directement reliée en point-à-point à toutes les autres, chaque liaison étant régie en fonction des besoins des deux unités reliées à ses extrémités.

L'invention propose aussi une installation de communication, notamment de type numérique à intégration de services, comportant une pluralité d'unités constitutives, spécialisées et modulaires, qui sont amenées à communiquer entre elles suivant leurs spécialisations respectives et en fonction des services de communication mis en oeuvre, par l'intermédiaire de liaisons physiques, de type point-à-point, reliant chacune deux des unités de l'installation ayant à communiquer entre elles.

Selon une caractéristique de l'invention, l'installation comporte des liaisons physiques, point-à-point de type électrique, regroupées sur une carte, dite de fond de panier, réalisée sous la forme d'un circuit multicouche comportant des positions de carte d'unité matérialisées par des moyens de connexion pour carte d'unité, chaque position de carte, équipée ou non, y étant directement reliée en point-à-point à toutes les autres, chaque liaison étant régie en fonction des besoins des deux unités reliées à ses extrémités.

L'invention, ses caractéristiques et ses avantages sont précisés dans la description qui suit, en liaison avec les figures répertoriées ci-dessous.

La figure 1 présente un schéma de principe d'un réseau d'interconnexion, pour installation de communication, selon l'invention.

La figure 2 présente un schéma d'un exemple pratique partiel de réseau d'interconnexion selon l'invention se rapportant spécifiquement aux unités concernées par la commutation de paquets.

La figure 3 présente un schéma d'un autre exemple partiel du même réseau se rapportant spécifiquement aux unités concernées par la commutation de signaux vidéo.

La figure 4 présente un exemple d'architecture décentralisée adaptée à la mise en oeuvre d'un réseau d'interconnexion selon l'invention.

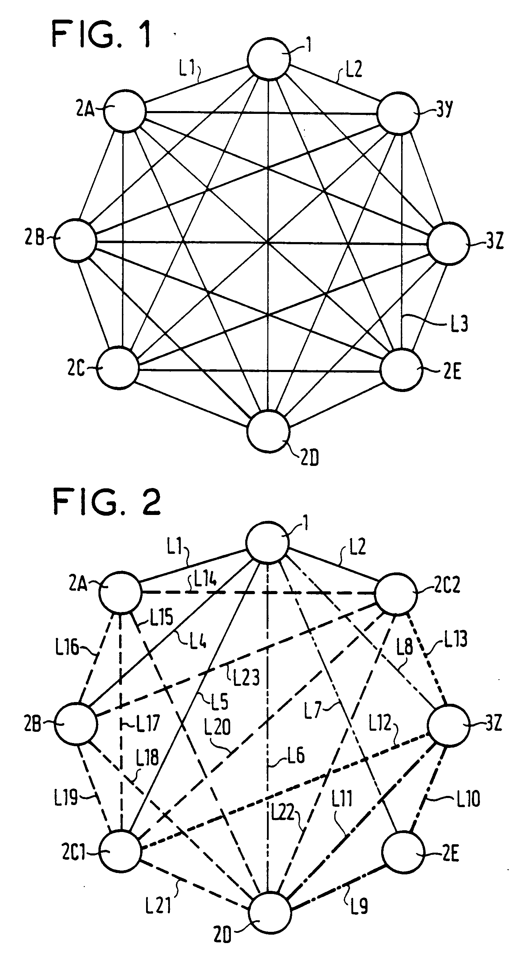

Le réseau d'interconnexion présenté en figure 1 est destiné à relier, entre elles, les unités constitutives d'une installation de communication, notamment une installation d'intercommunication ou un commutateur téléphonique, de type numérique à intégration de services.

Ces unités constitutives sont pratiquement aménagées sur des cartes porteuses individuelles qui sont regroupées à l'intérieur d'une même structure, de type armoire ou coffret, où se situe donc le coeur d'une installation.

Une installation de communication comporte classiquement une carte pour une unité de commande 1 habituellement organisée autour d'au moins un processeur, muni de mémoires mortes et/ou vives, ces divers éléments constitutifs bien connus de l'homme de métier, n'étant pas représentés ici.

Une installation de communication, telle qu'ici envisagée comporte aussi des cartes individuelles pour des unités d'entrée-sortie ou coupleurs 2 destinés à assurer la transmission généralement bidirectionnelle d'informations entre des instruments de communication, tels que des postes, des terminaux, des serveurs ou tout autre équipement utilisateur ou fournisseur.

Ces instruments de communication connus qui ne sont pas figurés ici, sont susceptibles d'être rattachés, comme il est connu, soit directement à l'installation considérée par exemple par des liaisons filaires, soit indirectement par l'intermédiaire des liaisons qui relient l'installation aux autres installations, auxquelles ces instruments sont alors directement rattachés.

Les dites autres installations et leurs liaisons d'interconnexion qui ne sont pas directement concernées par la présente invention, ne sont ni figurées ni décrites ici; il en est de même pour les liaisons reliant les coupleurs 2, d'une part aux instruments de communication qui leur sont éventuellement rattachés dans l'installation considérée, d'autre part aux autres installations.

L'installation de communication ici envisagée comporte encore des cartes pour des unités auxiliaires 3 destinées à assister une ou plusieurs autres unités en assurant une même fonction pour elle(s), par exemple une opération spécifique de transcodage nécessaire tant au(x) coupleur(s) 2 transmettant les informations à transcoder qu'à l'unité de commande chargée de la supervision des opérations relatives à ces informations dans l'installation.

De telles cartes d'unités auxiliaires 3 sont aussi susceptibles d'être prévues lorsqu'une seule carte ne suffit pas à l'installation d'une unité 1 ou 2, comme cela est connu.

Selon l'invention il est prévu d'unir par une liaison physique individuelle chaque unité 1, 2 ou 3 avec chacune des autres unités avec lesquelles elle est amenée à directement échanger des informations.

En théorie, chaque unité 1, 2 ou 3 d'une installation de communication comportant "n " unités est susceptible d'être connectée en point-à point à chacune des "n-1" autres unités de l'installation, ainsi qu'on le voit sur la figure 1.

Chaque liaison L, telle L1 entre l'unité de commande 1 et le coupleur 2A est adaptée aux besoins spécifiques des deux unités concernées et peut, si besoin est, être constituée et gérée de manière totalement différente de toutes les autres liaisons de l'installation, telles notamment L2 entre les unités 1 et 3Y, L3 entre les unités 2E et 3Y, ainsi qu'il sera montré plus loin.

Une même unité est donc susceptible d'être reliée à plusieurs liaisons différemment constituées et/ou gérées, sachant que dans la pratique le nombre de liaisons différentes connectées à une même unité est limité, chaque unité n'ayant de plus à être relié qu'à un nombre lui aussi limité d'autres unités.

Ainsi la figure 2 montre un exemple d'un sous-ensemble du réseau d'interconnexion d'une installation de communication, qui est relatif aux liaisons entre unités concernées par les informations transmises sous forme de paquets pour lesquelles l'installation assure une commutation, selon la technique dite de commutation de paquets.

Pour ce type d'application il est, par exemple, prévu dans l'installation la carte d'unité de commande 1, des cartes de coupleurs spécialisés 2A, 2B, 2C, 2D, 2E et une carte d'unité auxiliaire 3Z.

La carte de coupleur 2A assure la desserte des abonnés de l'installation qui sont dotés d'instruments de communication aptes à émettre ou recevoir des informations transmises par paquets, la carte de coupleur 2B est une carte d'interface normalisée, pour accès de type SO à un réseau numérique à intégration de services tel que défini par le Comité Consultatif International Télégraphique et Téléphonique (CCITT).

Les cartes de coupleur 2C1, 2C2 sont deux interfaces pour liaisons externes de transmission d'informations, de type liaison multiplexe temporelle à débit de 2 Mb/s selon la recommandation G.704 du CCITT, qui permettent la transmission d'octets de signaux de parole échantillonnés et codés MIC, ainsi que de données par l'intermédiaire de canaux B isochrones, normalisés, ayant un débit nominal de 64 kb/s, ces liaisons n'étant pas représentées ici.

La carte d'unité auxiliaire 3Z est ici une carte de traitement spécialisé des paquets, communément exploitée par les deux interfaces que comportent les cartes 2C1, 2C2 et par deux autres cartes de coupleur 2D et 2E.

Ces cartes de coupleur 2D et 2E sont des cartes d'accès respectivement à un réseau local normalisé de type ETHERNET et à un réseau normalisé de type urbain, dit MAN, l'un et l'autre aptes à transmettre des informations transcodées sous forme de paquets de données numériques.

L'adjonction d'une unité auxiliaire 3 reliée en point-à point à une ou plusieurs unité(s) qu'elle assiste par exemple pour une fonction déterminée présente un avantage déterminant par rapport à une solution où cette unité auxiliaire partagerait une liaison commune avec la ou les unités qu'elle assiste et éventuellement d'autres unités, notamment dans la mesure où cette liaison point-à-point peut être très précisément adaptée aux seuls besoins des unités desservies, sans contraintes dues aux autres unités, ce qui permet une adéquation maximale des coûts aux performances demandées.

Comme indiqué ci-dessus pour le cas particulier où une unité auxiliaire est impliquée, d'une manière générale chaque liaison point-à-point entre deux unités transporte les informations échangées entre ces unités par les moyens et avec les procédures les mieux adaptées à ces unités, ainsi les liaisons individuelles L1, L2, L4, L5 entre l'unité de commande 1 et chacune des unités 2A, 2C2, 2B et 2C1 sont ici toutes des liaisons, de type série par fil, tel qu'évoqué ci-dessus.

Les liaisons individuelles L6, L7, L8 entre l'unité de commande 1 et respectivement l'unité 2D, 2E ou 3Z, sont également des liaisons ,ici de type série et par fil régies pour permettre une transmission de signalisation en un mode paquet local, propre à l'installation et adapté aux besoins spécifiques d'au moins l'une des unités desservies.

Les liaisons point-à-point L9, L10 et L11 entre l'unité 2D, l'unité 2E et l'unité 3Z sont aussi des liaisons par fil qui sont régies en mode paquet pour permettre une transmission de la signalisation telle que prévue au niveau des coupleurs spécialisés et normalisés qui constituent les unités 2D, 2E.

Les liaisons L12, L13 entre l'unité 3Z et respectivement l'une ou l'autre des unités 2C1, 2C2 sont ici de type série, par fil ou piste, elles sont régies de manière à transmettre des informations en un mode paquet qui lui aussi est susceptible d'être spécifique.

Les liaisons restantes établies, ici référencées L14 à L23 qui sont de type série et par fil, sont prévues pour une transmission de signalisation en point-à point par canal B entre celle parmi les paires d'unités que respectivement chacune dessert.

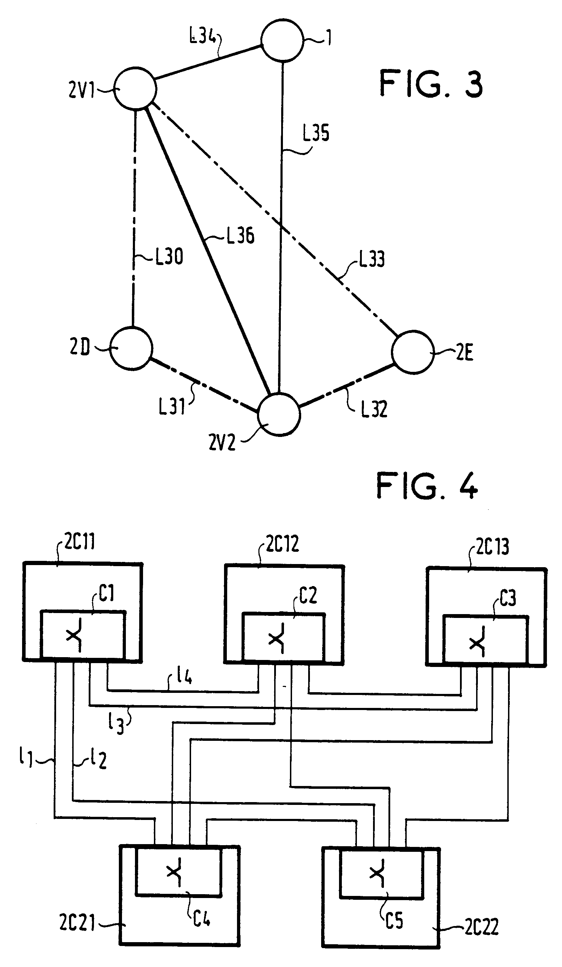

La figure 3 montre un autre exemple de sous-ensemble du réseau d'interconnexion d'une installation de communication, où seules sont montrées les cartes relatives aux unités impliquées dans la transmission d'informations vidéo.

Ces cartes sont ici celles de l'unité de commande 1, des coupleurs 2D et 2E donnant respectivement accès au réseau locaux ETHERNET et MAN évoqués plus haut et deux cartes de coupleur vidéo 2V1, 2V2.

Les liaisons L30 à L33 reliant respectivement l'unité 2D aux coupleurs vidéo 2V1 et 2V2, et l'unité 2E à ces mêmes coupleurs seront des liaisons par fil, régies en mode paquet pour permettre une transmission identique à celle prévue pour les liaisons L9 à L11 évoquées plus haut.

Les liaisons L34 et L35 entre les coupleurs vidéo 2V1 et 2V2 et l'unité de commande 1 sont ici analogues aux liaisons L1, L2.

La liaison L36 entre les coupleurs vidéo 2V1 et 2V2 est par exemple une liaison par fibre optique régie par un protocole spécifiquement adapté aux besoins vidéo.

Le réseau d'interconnexion selon l'invention se caractérise par le fait qu'il est composé de sous-ensembles fonctionnels au moins relativement indépendants combinés dans une structure ouverte permettant aisément l'adjonction de nouveaux services par adjonction de sous-ensembles venant s'ajouter aux existants sans modifier les transmissions préexistantes entre unités elles aussi préexistantes.

Contrairement à ce qui se passe avec les réseaux d'interconnexion classiques, l'adjonction de nouvelles unités et de nouveaux services ne réduit pas les possibilités de transmission sur les liaisons préexistantes, mais entraîne au contraire une augmentation des possibilités globales, ce qui permet notamment un coût réduit d'une installation à faible capacité et en particulier dans le cas d'installation pour lesquelles sont prévues des extensions échelonnées dans le temps au fur et à mesure de la croissance des besoins.

L'architecture d'une installation de communication n'est pas réellement dépendante du réseau d'interconnexion selon l'invention qui est apte à entrer tant dans le cadre d'une architecture centralisée d'installation que dans le cadre d'une architecture décentralisée, dont un exemple est ici donné en relation avec la figure 4.

Cette architecture décentralisée est susceptible d'être mise en oeuvre pour diverses applications dans une installation, à titre d'exemple elle est ici présentée appliquée à l'application commutation de circuit c'est-à-dire des signaux voix-données transmis vers l'installation par des voies de liaisons multiplexes temporelles, telles qu'évoquées plus haut en liaison avec les coupleurs 2C1, 2C2 de la figure 2.

Lorsque le nombre de tels coupleurs est supérieur à deux, chacun d'eux est relié aux autres par des liaisons point-à-point, comme on le voit sur la figure 4 montrant cinq coupleurs 2C11, 2C12, 2C13, 2C21, 2C22 identiques et correspondants aux coupleurs 2C1 et 2C2 mentionnés ci-dessus.

A cet effet chacun de ces cinq coupleurs comporte une liaison "l" éventuellement multifilaire avec chacun des quatre autres, telles les liaisons l1 à l4 reliant le coupleur 2C11 aux quatre autres. Chacun des cinq coupleurs comporte alors un commutateur individuel C lui permettant de se relier sélectivement à l'une ou l'autre des quatre liaisons qui l'unissent aux quatre autres coupleurs, tel le commutateur C1 du coupleur 2C11 aux commutateurs C2, C3, C4, C5 des coupleurs 2C12 , 2C13, 2C21, 2C22, via les liaisons l1 à l4.

Si par exemple trente voies temporelles sont traitées par chacun des cinq coupleurs, chaque commutateur C1 à C5 est apte à relier les trente voies qui lui sont affectées à toutes les autres voies de l'ensemble desservi par les autres. Une même architecture décentralisée est également envisageable pour les coupleurs de commutation de paquet d'un même type ou encore pour la distribution d'énergie aux différents coupleurs d'une installation.

Dans ce dernier cas chaque coupleur assure lui-même la fourniture en tensions et courants divers dont il a besoin à partir d'une unique liaison, non figurée, chargée de l'alimenter sous une tension unique et avec un courant nominal donné.

Dans les différents cas présentés, une bonne sécurité est susceptible d'être obtenue à un coût réduit du fait de la séparation effective des liaisons, elles-mêmes peu coûteuses en raison de leur simplicité et de celle relatives des procédures qui y sont mises en oeuvre puisque dans tous les cas seules deux unités sont directement concernées.

Comme montré ci-dessus, les unités sont susceptibles d'être organisées de différentes manières en fonction de choix individuels et par exemple de manière à notamment former une chaîne, une boucle fermée ou une étoile, un tel choix étant aisément optimisable à l'occasion d'extensions de l'installation par simple ajout d'unités et de liaisons de type point-à-point.

Comme indiqué plus haut, il est classique de grouper les différentes cartes correspondant aux diverses unités constituant le coeur d'une installation de communication à l'intérieur d'une même structure, de type armoire ou coffret, où ces cartes disposées en parallèle se connectent par une de leurs extrémités à une carte d'interconnexion, dite de fond de panier, disposée perpendiculairement à elles.

Dans un exemple de réalisation d'un réseau d'interconnexion selon l'invention, il est prévu une carte de fond de panier susceptible d'interconnecter jusqu'à trente cartes dans un ordre susceptible d'être déterminé selon les besoins, sans contrainte due à la carte de fond de panier elle-même.

Cette dernière comporte alors des moyens de connexion modulaires, équipés ou non, pour chacune des trente positions de carte d'unité possibles, ainsi que les liaisons correspondantes.

Dans l'exemple envisagé, chaque position de carte est reliée à chacune des vingt neuf autres par une liaison point-à-point bidirectionnelle de la carte de fond de panier, ainsi qu'en boucle vers elle-même, de manière à permettre des émissions, à partir d'une carte d'unité qu'elle interface, vers toutes les positions de cartes du fond de panier, y compris elle-même, et la réception, des émissions en provenance de n'importe laquelle des positions de carte, là aussi y compris elle-même.

Dans une forme de réalisation, où des liaisons bidirectionnelles, point-à point, à quatre conducteurs sont prévues entre positions de carte, l'ensemble des conducteurs formant ces liaisons est par exemple regroupé sur une carte de fond de panier réalisée sous la forme d'un circuit multicouche.

Chaque carte d'unité placée dans une position donnée, qui est potentiellement susceptible de communiquer en émission et/ou en réception avec toutes les cartes reliées au même fond de panier, y compris elle-même, ne communique en fait qu'avec celles qui sont compatibles avec elle sur le plan de la communication, des échanges d'informations par l'intermédiaire des liaisons du réseau d'interconnexion permettant aux diverses cartes compatibles entre elles de se connaître.

## Revendications

1. Réseau d'interconnexion pour coeur d'installation de communication, notamment de type numérique à intégration de services, comportant une pluralité d'unités constitutives (1, 2, 3), spécialisées et modulaires, communiquant entre elles suivant leurs spécialisations respectives et en fonction des services de communication mis en oeuvre, par l'intermédiaire de liaisons physiques (L), de type point-à-point, reliant chacune deux des unités de l'installation ayant à communiquer entre elles, caractérisé en ce qu'il comporte des liaisons physiques, point-à-point et de type électrique, qui sont regroupées sur une carte, dite de fond de panier, réalisée sous la forme d'un circuit multicouche comportant des positions de carte d'unité matérialisées par des moyens de connexion pour carte d'unité, chaque position de carte, équipée ou non, y étant directement reliée en point-à-point à toutes les autres, chaque liaison étant régie en fonction des besoins des deux unités reliées à ses extrémités.

2. Installation de communication, notamment de type numérique à intégration de services, comportant une pluralité d'unités constitutives (1, 2, 3), spécialisées et modulaires, communiquant entre elles suivant leurs spécialisations respectives et en fonction des services de communication mis en oeuvre, par l'intermédiaire de liaisons physiques (L), de type point-à-point, reliant chacune deux des unités de l'installation ayant à communiquer entre elles, caractérisée en ce qu'elle comporte des liaisons physiques, point-à-point et de type électrique, qui sont regroupées sur une carte, dite de fond de panier, réalisée sous la forme d'un circuit multicouche comportant des positions de carte d'unité matérialisées par des moyens de connexion pour carte d'unité, chaque position de carte, équipée ou non, y étant directement reliée en point-à-point à toutes les autres, chaque liaison étant régie en fonction des besoins des deux unités reliées à ses extrémités.

3. Installation de communication, selon la revendication 2, caractérisée en ce qu'elle comporte des unités identiques qui, identiquement reliées par des liaisons individuelles aux unités avec lesquelles elles sont amenées à communiquer, sont éventuellement reliées à des liaisons différentes et/ou régies différemment qui aboutissent alors à des unités ayant des types différents.

4. Installation de communication, selon la revendication 2, caractérisée en ce qu'elle comporte au moins une unité auxiliaire (3) d'au moins une autre unité constitutive (1 ou 2) qui est directement reliée à cette unité constitutive par une liaison individuelle de type point-à-point.

5. Installation de communication, selon la revendication 2, caractérisée en ce qu'elle comporte des unités identiques qui, interconnectées par des liaisons individuelles identiques, comportent chacune un commutateur individuel auquel aboutissent toutes les liaisons identiques individuelles reliant l'unité considérée aux autres unités identiques.

## Patentansprüche

1. Vermittlungsnetz für das Herzstück einer Fernmeldeanlage, insbesondere vom ISDN-Typ, die mehrere spezialisierte und modulare Einheiten (1, 2, 3) besitzt, welche gemäß ihrer jeweiligen Spezialisierung und abhängig von den implementierten Fernmeldediensten über physische Punkt-zu-Punkt-Verbindungen (L) miteinander verkehren, die jeweils zwei der Anlagen miteinander verbinden, die miteinander verkehren sollen, dadurch gekennzeichnet, daß es physische Punkt-zu-Punkt-Verbindungen vom elektrischen Typ enthält, die auf einer sogenannten Verdrahtungskarte in Form einer Mehrschichtenschaltung zusammengefaßt sind, wobei diese Karte Steckpositionen für Karten von Einheiten besitzt, die durch Anschlußmittel für die Karten je einer Einheit materialisiert sind, und wobei jede Kartenposition, ob nun besetzt oder nicht, unmittelbar über eine Punkt-zu-Punkt-Verbindung mit allen anderen Positionen verbunden ist und jede Verbindung abhängig von den Bedürfnissen der beiden an ihren Enden angeschlossenen Einheiten betrieben wird.

2. Fernmeldeanlage, insbesondere vom ISDN-Typ, die mehrere spezialisierte und modulare Einheiten (1, 2, 3) besitzt, welche gemäß ihrer jeweiligen Spezialisierung und abhängig von den implementierten Fernmeldediensten über physische Punkt-zu-Punkt-Verbindungen (L) miteinander verkehren, die jeweils zwei der Anlagen miteinander verbinden, die miteinander verkehren sollen, dadurch gekennzeichnet, daß die Einrichtung physische Punkt-zu-Punkt-Verbindungen vom elektrischen Typ enthält, die auf einer sogenannten Verdrahtungskarte in Form einer Mehrschichtenschaltung zusammengefaßt sind, wobei diese Karte Steckpositionen für Karten von Einheiten besitzt, die durch Anschlußmittel für die Karten je einer Einheit materialisiert sind, und wobei jede Kartenposition, ob nun besetzt oder nicht, unmittelbar über eine Punkt-zu-Punkt-Verbindung mit allen anderen Positionen verbunden ist und jede Verbindung abhängig von den Bedürfnissen der beiden an ihren Enden angeschlossenen Einheiten betrieben wird.

3. Fernmeldeanlage nach Anspruch 2, dadurch gekennzeichnet, daß sie identische Einheiten enthält, die auf gleiche Weise über individuelle Verbindungen mit den Einheiten, mit denen sie in Verkehr treten sollen, verbunden sind und die ggf. an unterschiedliche und/oder unterschiedlich betriebene Verbindungen angeschlossen sind, die dann zu Einheiten eines anderen Typs führen.

4. Fernmeldeanlage nach Anspruch 2, dadurch gekennzeichnet, daß sie mindestens eine weitere Einheit (1 oder 2) enthält, die unmittelbar mit der ersten Einheit über eine individuelle Punkt-zu-Punkt-Verbindung verbunden ist.

5. Fernmeldeanlage nach Anspruch 2, dadurch gekennzeichnet, daß sie identische Einheiten enthält, die über individuelle identische Verbindungen miteinander verbunden sind und je einen individuellen Schalter aufweisen, an dem alle identischen individuellen Verbindungen ankommen, die die betrachtete Einheit mit den anderen identischen Einheiten verbinden.

## Claims

1. Interconnect network for the core of a communication installation, for example an integrated services digital communication installation, said network including a plurality of dedicated modular units (1, 2, 3) communicating with each other in accordance with their respective specialities and in accordance with the communication services provided by way of point-to-point physical links (L) each connecting two installation units needing to communicate with each other, characterised in that it includes physical point-to-point electrical links combined on a multilayer backplane printed circuit board having unit board slots in the form of unit board connecting means, each slot, whether the respective circuit board is present or not, being connected by direct point-to-point links to all the others, each link being operated in accordance with the requirements of the two units connected to its ends.

2. Communication installation, for example an integrated services digital communication installation, including a plurality of dedicated modular units (1, 2, 3) communicating with each other in accordance with their respective specialities and in accordance with the communication services provided via point-to-point physical links (L) each connecting two installation units needing to communicate with each other, characterised in that it comprises physical point-to-point electrical links combined on a multilayer backplane printed circuit board having unit board slots in the form of unit board connection means, each slot, whether the respective circuit board is present or not, being connected by direct point-to-point links to all the others, each link being operated in accordance with the requirements of the two units connected to its ends.

3. Communication installation according to claim 2 characterised in that it comprises identical units identically connected by individual links to the units with which they need to communicate and which can be connected to different links or links operated differently connecting them to units of different types.

4. Communication installation according to claim 2 characterised in that it includes at least one auxiliary unit (3) of at least one other unit (1 or 2) connected direct to said other unit by an individual point-to-point link.

5. Communication installation according to claim 2 characterised in that it includes identical units interconnected by identical individual links and each including an individual switch at which terminate all the identical individual links connecting the unit in question to other identical units.
